# EUROPEAN PATENT SPECIFICATION

(11) **EP 0 606 867 B1**
(45) Date of publication and mention of the grant of the patent: **05.12.2001**
(21) Application number: 94100238.8
(22) Date of filing: 10.01.1994
(51) Int. Cl.: H03H 2/00, H01F 10/24

(54) **Material for magnetostatic-wave elements**
Material für Geräte mit magnetostatischen Wellen
Matériau pour dispositifs à ondes magnétostatiques

(30) Priority: 11.01.1993 JP 1953893
(43) Date of publication of application: 20.07.1994
(73) Proprietor: MURATA MANUFACTURING CO., LTD., Nagaokakyo-shi Kyoto-fu 226 (JP)
(72) Inventor: Fujii, Takashi, Otokuni-gun, Kyoto-fu (JP); Takagi, Hiroshi, Ohtsu-shi, Shiga-ken (JP)
(74) Representative: Schoppe, Fritz, Dipl.-Ing.

(56) References cited:
- FR-A- 1 526 482
- US-A- 3 131 082
- US-A- 4 968 954
- JOURNAL OF CRYSTAL GROWTH, vol.27, no.12, December 1974, AMSTERDAM NL pages 287 - 298 R.HISKES
- JOURNAL OF CRYSTAL GROWTH, 1987, vol. 84, pages 237 to 240

## Description

The present invention relates to a material for magnetostatic-wave elements and, more particularly, to a material for formation of single-crystal magnetic garnet films used in magnetostatic-wave elements.

As a material for single-crystal magnetic garnet used in magnetostatic wave elements, there has been used an yttrium-iron-garnet (Y₃Fe₅O₁₂, hereinafter referred to as "YIG") which is of particular importance. In particularly, YIG is extremely small in magnetic resonance half linewidth (ΔH), thus making it possible to reduce a difference between input and output signals of magnetostatic wave (MSW) elements.

Single-crystal YIG films are generally produced by liquid-phase epitaxy (LPE) process in which raw materials for the garnet film, ferric oxide (Fe₂O₃) and yttrium oxide (Y₂O₃), are dissolved in a molten oxide solution composed of lead oxide (PbO) and boric oxide (B₂O₃), and a single-crystal substrate of nonmagnetic gadolinium-gallium-garnet (Gd₃Ga₅O₁₂, hereinafter referred to as "GGG") is immersed into the solution for deposition of single-crystal thin film.

However, it often happens that it is impossible to obtain desired magnetic properties or to reproduce the magnetic properties even if the single-crystal YIG thin films were grown under the same deposition conditions and subjected to the same thermal histories after film growth. In such a case, the magnetic properties are variable in the single-crystal YIG thin film, causing in a lowering of magnetic characteristics of magnetostatic wave elements employing such a single-crystal YIG thin film.

FR-A-152 6482 describes the formation of a thin monocrystalline synthetic garnet. Firstly, a monocrystalline substrate is mounted on a support and specific substances necessary for the formation of halide vapors are put into receptacles. Once the substances are put into a chamber of reaction, an appropriate gas is lead into the chamber of reaction and the gas passes over the reaction substances and enables the halide vapors to enter into the reaction chamber. At the same time, an oxidation gas is introduced via an inlet line into the reaction chamber and the halide vapors and the oxidation gas react and crystallize on the surface of the substrate and form a monocrystalline growth on the substrate. Afterwards, the gasses are evacuated from the chamber of reaction.

In the Journal of Crystal Growth, Vol. 27, No. 12, December 1974, pages 287 to 298, the LPE growth and characterization of magnetic garnets grown in BaO-based solvents is described, wherein BaF² is added into a BaO-B²O³ solvent.

It is the object underlying the present invention to provide a material and a method for forming a material for magnetic static wave elements with improved magnetic characteristics.

This object is achieved by a material according to claim 1 and by a method according to claim 6.

There is provided a material for magnetostatic wave elements consisting essentially of an yttrium-iron-garnet, Y₃Fe₅O₁₂, and at least one element of the halogen group incorporated therein. Thus, this material may be expressed by the general formula:

Y³⁺ ₃(Fe²⁺ ₓFe³⁺ ₅₋ₓ)O₁₂₋ₓX⁻¹ ₓ

The above at least one element of the halogen group is one ore more elements of group VII of the periodic table, i.e., at least one element selected from the group consisting of fluorine, chlorine, bromine, iodine and astatine. The content of at least one element of the halogen group in Y₃Fe₅O₁₂ is in the range of 0.001 to 0.1 wt%. The halogen (X) may be incorporated in the form of a halide such as FeX₃ (e.g., FeF₃, FeCl₃, FeBr₃, etc.) and YX₃ (e.g., YF₃, YCl₃, etc.)

According to one embodiment of, the present invention, there is further provided a material for magnetostatic wave elements consisting essentially of a magnetic single-crystal garnet and at least one element of the halogen group incorporated therein, said material having a composition expressed by the general formula:

(Y³⁺ ₃₋ₘMₘ) (Fe²⁺ ₓFe³⁺ ₅₋ₓ₋ₙM'ₙ)O₁₂₋ₓX⁻¹ ₓ

where M is at least one trivalent element, M' is at least one element of trivalent or divalent metals, X is at least one element of halogen group, 0 < m < 3, and 0 < n < 0.5. The content of at least one element of the halogen group in Y₃Fe₅O₁₂ is 0.001 to 0.1 wt%.

As the trivalent element M there may be used those such as Bi, Sb, and lanthanoide (La, Ce, Pr, Nd, Pm, Sm, Eu, Gd, Tb, Dy, Ho, Er, Tm, Yb, Lu). Typical metals used as M' are Ga, In, Tl, Co and Ni. These elements may be used alone or in combination.

In general, iron exhibits two valences and varies easily from divalent ions to trivalent ions or vice versa according to the surroundings. Theoretically, iron in the magnetic garnet film, e.g., YIG, should be present in the trivalent state since yttrium and oxygen present in the positive trivalent state and negative divalent state, respectively. However, if iron has varied from the trivalent state to the divalent state according to the deposition conditions or thermal histories thereafter, the results would be ununiformity of the magnetic properties of the single-crystal YIG. In this case, a part of iron, x, in YIG has varied from the trivalent state to the divalent state, the electrical equilibrium conditions is given by formula (1):

Y³⁺ ₃Fe²⁺ ₓFe³⁺ ₅₋ₓO_{12-x/2}□⁰ _{x/2} (1)

as the sum of positive charges and negative charges should be 0. From the standpoint of the neutralization of electrical charges, the composition is short of oxygen atoms entering the oxygen lattice by x/2. In order to make up for deficiency, point defects with no charges, so-called Schottky defects, are produced in the crystal by x/2, as expressed by □⁰ in Formula (1). Because, the single-crystal YIG thin films containing Fe²⁺ are chemically stabilized by the presence of such point defects in the crystal structure. However, the presence of point defects causes generation of local nuclear spins, resulting in considerable lowering of magnetostatic wave characteristics of the YIG film.

According to the present invention, such a problem is solved by incorporating at least one element of the halogen group into the single-crystal YIG. In this case, the point defects expressed by □⁰ in Formula (1) are replaced with univalent halogen atoms. Thus, the resultant composition is given by the formula (2):

Y³⁺ ₃Fe²⁺ ₓFe³⁺ ₅₋ₓO₁₂₋ₓX⁻¹ ₓ (2)

where X is at least one element of halogen group, i.e., at least one element selected from the group consisting of fluorine, chlorine, bromine, iodine, and astatine in group VII of the periodic table. Thus, no point defect is produced in the single-crystal and the neutralization of electronic charges is met by the presence of at least one element of the halogen group. Further, no partial nuclear spin takes place since the halogen atom, X⁻¹, takes the electron configuration equivalent to that in atoms of rare gas. Accordingly, it is possible to obtain stable single-crystal magnetic garnet films with excellent magnetic properties.

The above explanation can be applied to other magnetic single-crystal garnets expressed by the general formula:

(Y³⁺ ₃₋ₘMₘ)(Fe²⁺ ₓFe³⁺ ₅₋ₓ₋ₙM'ₙ)O₁₂₋ₓX⁻¹ ₓ

The above and other objects, features and advantages of the present invention will be apparent from the following explanation with reference to several examples thereof.
Fig. 1 is a graph showing ferromagnetic resonance spectrum (Lorentz type) for a single-crystal YIG thin film according to the present invention; and
Fig. 2 is a graph showing a ferromagnetic resonance spectrum for a single-crystal YIG thin film of the prior art.

### Example

Using the LPE process, there were prepared single-crystal magnetic garnet films in the following manner:
Powders of Fe₂O₃, FeF₃, Y₂O₃ were weighed, mixed and then added to a solvent composed of PbO and B₂O₃ to prepare a mixture consisting essentially of 9.0 mol% of Fe₂O₃, 0.5mol% of FeF₃, 0.5 mol% of Y₂O₃, 84.6 mol% of PbO and 5.4 mol% of B₂O₃. The resultant mixture was placed in a platinum crucible and heated to 1200 °C by an LPE furnace to prepare a homogeneous melt. The melt was then cooled to and kept at 900 °C at which crystal growth of YIG takes place. Then, a single-crystal GGG substrate was immersed into the melt to deposit a single-crystal YIG thin film on the substrate by the LPE process. After formation of the single-crystal YIG thin film, the substrate was drawn up from the melt and rotated at a high rate of revolution to remove the melt from the single-crystal YIG thin film. Analysis of the resultant single-crystal YIG thin film showed that the content of F in the thus produced film is 0.02 wt% of F.

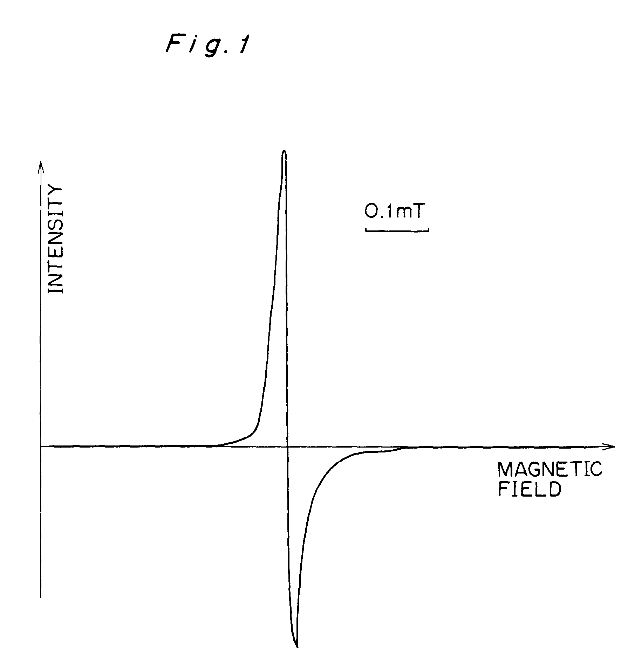

For samples of the resultant single-crystal YIG thin film, a ferromagnetic resonance spectrum was observed by an electron spin resonance (ESR) spectroscopy. The result is shown in Fig. 1.

From Fig. 1, it can be seen that the ferromagnetic resonance spectrum for the single-crystal YIG film of the present invention contains only one peak.

Further, the single-crystal YIG thin film was subjected to heat-treatment in oxygen gas at 900 °C for 6 hours, but no change was observed in the ferromagnetic resonance spectrum.

### Comparative Example

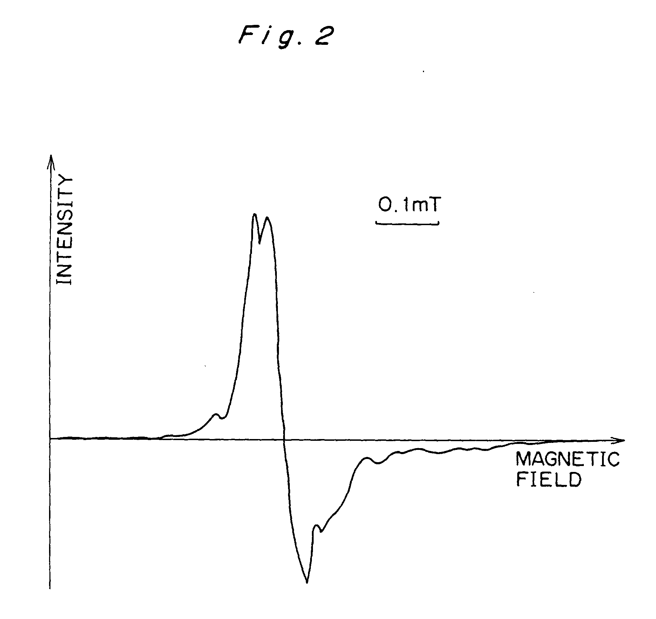

Using the same raw materials except FeF₃, there were prepared single-crystal YIG thin films containing no halogen atoms, in the same manner as Example. For a sample of the single-crystal YIG thin film thus produced, a ferromagnetic resonance spectrum was observed by the electron spin resonance spectroscopy. The result is shown in Fig. 2.

From this figure, it can be seen that the ferromagnetic resonance spectrum for the single-crystal YIG film of the prior art contains two peaks. Also, the heat-treatment of the single-crystal YIG film of the prior art showed that the ferromagnetic resonance spectrum varies with the thermal conditions applied to the film.

## Claims

1. A material for magnetostatic wave elements consisting essentially of an yttrium-iron-garnet, Y₃Fe₅O₁₂,
**characterized in that**
at least one element of the halogen group is incorporated into said yttrium-iron-garnet, wherein the content of said at least one element of the halogen group ranges from 0.001 to 0.1 wt%.

2. The material for magnetostatic wave elements according to claim 1, wherein the at least one element of the halogen group is one selected from the group consisting of fluorine, chlorine, bromine, iodine and astatine.

3. The material for magnetostatic wave elements according to claim 1 or 2 having a composition expressed by the general formula:
(Y³⁺ ₃₋ₘMₘ)(Fe²⁺ ₓFe³⁺ ₅₋ₓ₋ₙM'ₙ)O₁₂₋ₓX⁻¹ ₓ
where M is at least one trivalent element, M' is at least one element of trivalent or divalent metals, X is at least one element of the halogen group, 0 < m < 3, and 0 < n < 0,5.

4. The material for magnetostatic wave elements according to claim 3, wherein said element M is one or more elements selected from the group consisting of Bi, Sb and lanthanoide.

5. The material for magnetostatic wave elements according to claim 3 or 4, wherein said element M' is one or more elements selected from the group consisting of Ga, In, Tl, Co and Ni.

6. A method for forming a material for magnetostatic wave elements consisting essentially of an yttrium-iron-garnet, Y₃Fe₅O₁₂, comprising the step of
forming said yttrium-iron-garnet by liquid phase epitaxy; **characterized in that**
at least one element of the halogen group is incorporated into said yttrium-iron-garnet, wherein the content of said at least one element of the halogen group ranges from 0.001 to 0.1 wt%.

## Patentansprüche

1. Ein Material für Magnetostatische-Wellen-Elemente, das im wesentlichen aus einem Yttrium-Eisen-Granat, Y₃Fe₅O₁₂, besteht
**dadurch gekennzeichnet, daß**
zumindest ein Element der Halogengruppe in dem Yttrium-Eisen-Granat enthalten ist, wobei der Gehalt des zumindest einen Elements der Halogengruppe zwischen 0,001 und 0,1 Gewichtsprozent variiert.

2. Das Material für Magnetostatische-Wellen-Elemente gemäß Anspruch 1, bei dem das zumindest eine Element der Halogengruppe aus der Gruppe ausgewählt wird, die aus Fluor, Chlor, Brom, Jod und Astat besteht.

3. Das Material für Magnetostatische-Wellen-Elemente gemäß Anspruch 1 oder 2, das eine Zusammensetzung aufweist, die durch folgende allgemeine Formel ausgedrückt wird:
(Y³⁺ ₃₋ₘMₘ) (Fe²⁺ ₓFe³⁺ ₅₋ₓ₋ₙM'ₙ)O₁₂₋ₓX⁻¹ ₓ
wobei M zumindest ein dreiwertiges Element ist, M' zumindest ein Element eines dreiwertigen oder zweiwertigen Metalls ist, X zumindest ein Element der Halogengruppe ist, und wobei 0 < m < 3 und 0 < n < 0,5 ist.

4. Das Material für Magnetostatische-Wellen-Elemente gemäß Anspruch 3, bei dem das Element M eines oder mehrere Elemente ist, das aus der Gruppe ausgewählt wird, die aus Bi, Sb und Lanthanoid besteht.

5. Das Material für Magnetostatische-Wellen-Elemente gemäß Anspruch 3 oder 4, bei dem das Element M' eines oder mehrere Elemente ist, das aus der Gruppe ausgewählt wird, die aus Ga, In, Tl, Co und Ni besteht.

6. Ein Verfahren zum Bilden eines Materials für Magnetostatische-Wellen-Elemente, das im wesentlichen aus einem Yttrium-Eisen-Granat, Y₃Fe₅O₁₂, besteht, wobei das Verfahren den folgenden Schritt aufweist:
Bilden des Yttrium-Eisen-Granats durch Flüssigphasen-Epitaxie;
**dadurch gekennzeichnet, daß**
zumindest ein Element der Halogengruppe in dem Yttrium-Eisen-Granat enthalten ist, wobei der Gehalt des zumindest einen Elements der Halogengruppe zwischen 0,001 und 0,1 Gewichtsprozent variiert.

## Revendications

1. Matériau pour des éléments à ondes magnétostatiques comprenant essentiellement un grenat yttrium-fer, à savoir Y₃Fe₅O₁₂,
**caractérisé en ce que** :
au moins un élément du groupe halogène est incorporé dans ledit grenat yttrium-fer, dans lequel la teneur dans ledit au moins un élément du groupe halogène s'inscrit dans la plage qui va de 0,001% en poids à 0,1% en poids.

2. Matériau pour des éléments à ondes magnétostatiques selon la revendication 1, dans lequel l'au moins un élément du groupe halogène est un élément choisi parmi le groupe comprenant fluor, chlore, bromure, iodure et astate.

3. Matériau pour des éléments à ondes magnétostatiques selon la revendication 1 ou 2, présentant une composition qui est exprimée par la formule générale :
(Y³⁺ ₃₋ₘMₘ) (Fe²⁺ ₓFe³⁺ ₅₋ₓ₋ₙM'ₙ)O₁₂₋ₓX⁻¹ ₓ
où M est au moins un élément trivalent, M' est au moins un élément de métaux trivalents ou divalents, X est au moins un élément du groupe halogène, 0 < m < 3 et 0 < n < 0,5.

4. Matériau pour des éléments à ondes magnétostatiques selon la revendication 3, dans lequel ledit élément M est un ou plusieurs éléments choisis parmi le groupe comprenant Bi, Sb et lanthanoïde.

5. Matériau pour des éléments à ondes magnétostatiques selon la revendication 3 ou 4, dans lequel ledit élément M' est un ou plusieurs éléments choisis parmi le groupe comprenant Ga, In, Tl, Co et Ni.

6. Procédé pour former un matériau pour des éléments à ondes magnétostatiques comprenant essentiellement un grenat yttrium-fer, à savoir Y₃Fe₅O₁₂, comprenant l'étape de formation dudit grenat yttrium-fer au moyen d'une épitaxie en phase liquide,
**caractérisé en ce que** :
au moins un élément du groupe halogène est incorporé dans ledit grenat yttrium-fer, dans lequel la teneur dans ledit au moins un élément du groupe halogène s'inscrit dans la plage qui va de 0,001% en poids à 0,1% en poids.
